Europäisches Patentamt

European Patent Office

Office européen des brevets

(19)

(11) **EP 1 612 942 A1**

(12) **EUROPEAN PATENT APPLICATION**

(43) Date of publication:
**04.01.2006 Bulletin 2006/01**

(51) Int Cl.:
**H03K 23/66** (2006.01)

(21) Application number: **04015423.9**

(22) Date of filing: **30.06.2004**

(84) Designated Contracting States:
**AT BE BG CH CY CZ DE DK EE ES FI FR GB GR
HU IE IT LI LU MC NL PL PT RO SE SI SK TR**
Designated Extension States:
**AL HR LT LV MK**

(71) Applicant: **Infineon Technologies AG
81669 München (DE)**

(72) Inventor: **Lewis, Michael
195 52 Märsta (SE)**

(74) Representative: **Lange, Thomas et al
Patentanwälte
Lambsdorff & Lange
Dingolfinger Strasse 6
81673 München (DE)**

(54) **A fractional divider system and method**

(57)    The present invention relates to a fractional divider system (100) for low-power timer with reduced timing error at wakeup. The fractional divider system (100) comprises a fractional divider means (102) operable to produce an output signal with a frequency $F_C$ with the following relation to a reference clock frequency $F_{LP}$:

$$F_{LP} = \left( M + \frac{N}{P_{DIV}} \right) \times F_C$$

, wherein $P_{DIV}$ is the period of said fractional divider means (102), M is the integer part of the division ratio, and N is the magnitude of the fractional part of the division ratio. The fractional divider system (100) also comprises a to said fractional divider means (102) connected high speed crystal oscillator means (104) operable to start on wakeup from the low power mode. The fractional divider system (100) also comprises a to said high speed crystal oscillator means (104) connected high speed clock divider means (106). The high speed crystal oscillator means (104) also is operable to sample the output signal and a current state of the total timing error from said fractional divider means (102). The sampled output signal trigger said high speed clock divider means (106) and said sampled current state of the total timing error preloads said high speed clock divider means (106), which is operable to synchronise the first pulse of the output clock signal to the ideal clock timing to an accuracy within 1,5 periods of the high speed clock.

FIG 3

EP 1 612 942 A1

## Description

Field of invention

The present invention relates in a first aspect to a fractional divider system for low-power timer with reduced timing error at wakeup.

According to a second aspect the present invention relates to a method for reducing timing error at wakeup for low-power timer.

According to a third aspect the present invention relates to at least one computer program product for reducing timing error at wakeup for low-power timer.

Background of the invention

Low power devices are often designed such that they exploit periods of inactivity to deactivate non-necessary functions and enter an "idle" mode. For instance, it is common to deactivate the high speed crystal oscillator (operating at 10s of MHz) that provides the timing reference for the digital and also possibly analogue components. This reduces the power consumption of the device dramatically.

In many cases, it is necessary to be able to maintain an accurate timing reference during this idle period. For instance, a communications protocol implemented by the device may require that the device is reactivated to either send or receive messages at a particular point in time. Alternatively, if the device is woken up by an external signal, it may be necessary to determine accurately how much time has elapsed since the device entered low power mode.

An example of such a device is a Bluetooth communications circuit. The Bluetooth standard requires the maintenance of a transmission slot timer (control clock) operating at a rate of 1.6kHz, which is allowed a maximum frequency drift of 250ppm while in low power mode and a maximum timing jitter of 10$\mu$s on awakening. This timer is used to determine when the device should awaken to receive or transmit data.

Typically, when the Bluetooth device is embedded in a larger system such as a mobile phone, there will be an external timing reference available during the low power mode. Such a reference is typically derived from a 32.768kHz crystal oscillator, which consumes little power and is extremely cheap. Alternatively, an internal low-frequency oscillator may be used.

One approach is to make use of the low-power reference signal directly to determine when to leave low power mode. However, this requires that e.g. software calculate the number of low power reference clock cycles that corresponds to the required number of control clock cycles prior to entering low power mode, and then calculate a further fractional correction on leaving low power mode. This requires processing time, which limits the amount of time that can be spent in the low power mode.

An alternative approach is to use a fractional divider circuit to derive the 1.6kHz control clock from the available low-power reference signal. A fractional divider circuit produces an output signal with frequency $F_C$ with the following relationship to the reference clock frequency $F_{LP}$:

$$F_{LP} = \left( M + \frac{N}{P_{DIV}} \right) \times F_C$$

$P_{DIV}$ is the period of the fractional divider, M is the integer part of the division ratio, and N is the magnitude of the fractional part ($N < P_{DIV}$). The ratio is generally determined once for a given input and output frequency, and so does not represent a continuous overhead.

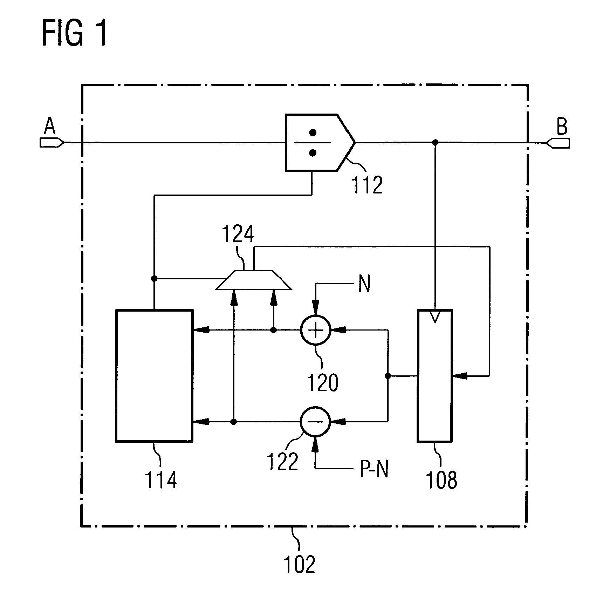

A standard implementation of a fractional divider is based on a simple integer divider (which generates a single output pulse once every M input pulses), with the integer division ratio alternated between M and (M+1) such that, over $P_{DIV}$ output clocks, the average division ratio is correct. An example of a digital circuit to perform this operation is shown in figure 1. In figure 1 there is disclosed a fractional divider means 102 operable to produce an output signal with a frequency $F_C$ with the following relation to a reference clock frequency $F_{LP}$:

$$F_{LP} = \left( M + \frac{N}{P_{DIV}} \right) * F_C$$

The fractional divider means 102 comprises an accumulator means 108 operable to keep track of the total timing error. The fractional divider means 102 also comprises an to said accumulator means 108 and to a reference clock A connected integer divider means 112 operable to divide the reference clock A with an integer division ratio of either M or M+1. The fractional divider means 102 also comprises a to said integer divider means 112 connected ratio selector means 114 operable to keep the total timing error minimised symmetrically around zero. The fractional divider means 102 also comprises an adding means 120 connected to said accumulator means 108, a subtracting means 122 connected to said accumulator means 108, and a multiplexer means 124 connected to said adding means 120, said subtracting means 122 and said ratio selector means 114. As is apparent from figure 1, the adding means 120 and the subtracting means 122 are also connected to said ratio selector means 114. The output clock from the fractional divider means 102 is denoted B. Every time a division ratio of M is selected, the output clock is produced with a period that is N/$P_{DIV}$ input clock cycles shorter than the ideal output clock period. Alternatively, when a division ratio of M+1 is selected the output clock is produced with a period that is ($1-N/P_{DIV}$) input clock cycles longer than the ideal output clock period. An accumulator is used to keep track of the total timing error: every time a division ratio of M is used, the accumulator is incremented by N, while every time a division ratio of M+1 is used, the accumulator is decremented by ($P_{DIV}-N$). At the beginning of each output clock cycle, the circuit determines which division ratio (M or M+1) will cause the least timing error with respect to the ideal clock output, and uses that division ratio.

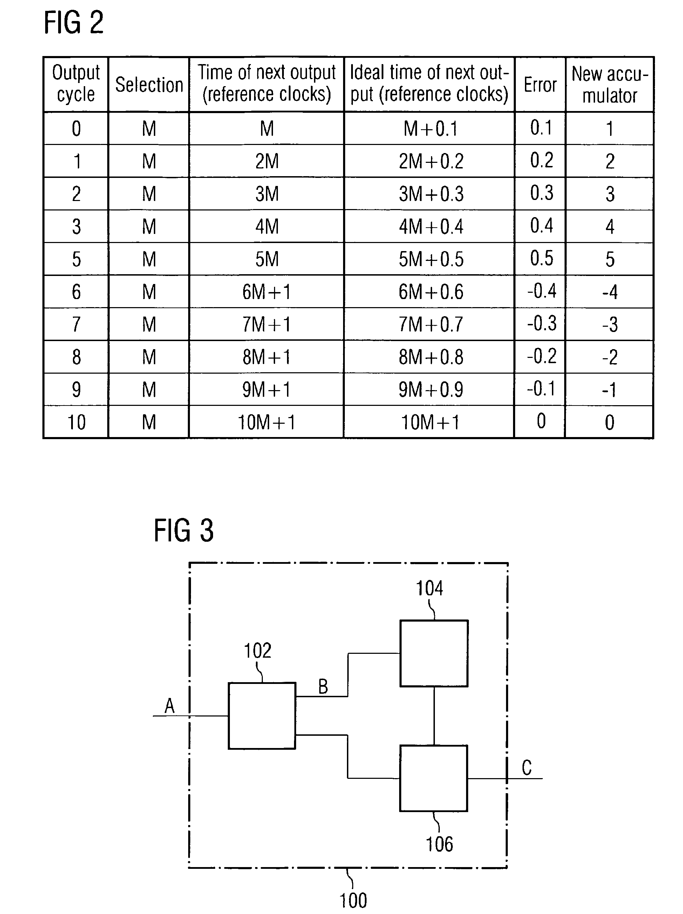

An example of how this is performed is shown in figure 2. In this example, the fractional part is set to 0.1 (i.e. N = 1, $P_{DIV}$ = 10). To generate the first cycle of the output clock, a division ratio of M is chosen. This results in an error of 0.1 (i.e. the output clock is produced 0.1 periods of the input clock too early). Had the ratio M+1 been used, the resulting output clock would instead have come 0.9 input clock cycles too late. At the beginning of each new output clock cycle, the same decision is made with the error gradually accumulating. By output cycle 4, the error has reached 0.5 (corresponding to an accumulator value 5): at this stage, choosing a division ratio of M would produce an error of +0.6, while choosing a ratio of M+1 would produce a smaller absolute error of -0.4. Hence, the circuit chooses a division ratio M+1.

The problem with this method of clock division is that, at any given instant, the error (jitter) from the output clock to the ideal clock can be up to half of an input clock cycle. For the case of a 32.768kHz clock this would result in a jitter of 15µs, which violates the 10µs jitter requirements for the Bluetooth control clock.

Summary of the invention

The object with the present invention is to solve the above-mentioned problems. This is achieved with a fractional divider system for low-power timer with reduced timing error at wakeup according to claim 1. The fractional divider system comprises a fractional divider means operable to produce an output signal with a frequency $F_C$ with the following relation to a reference clock frequency $F_{LP}$:

$$F_{LP} = \left( M + \frac{N}{P_{DIV}} \right) \times F_C$$

, wherein $P_{DIV}$ is the period of said fractional divider means, M is the integer part of the division ratio, and N is the magnitude of the fractional part of the division ratio. The fractional divider system also comprises a to said fractional divider means connected high speed crystal oscillator means operable to start on wakeup from the low-power mode. The fractional divider system also comprises a high speed clock divider means connected to said fractional divider means and to said high speed crystal oscillator means. The high speed crystal oscillator means is also operable to sample the output signal and sample a current state of the total timing error from said fractional divider means. The sampled output signal trigger said high speed clock divider means and the sampled current state of the total timing error preloads said high speed clock divider means, which is operable to synchronise the first pulse of the output clock signal to the ideal clock timing to an accuracy within 1,5 periods of the high speed clock.

An advantage with the fractional divider system according to the present invention is that the timing jitter due to the fractional divider system can be reduced to 1,5 high speed clock cycles, i.e. a small fraction of a microsecond. This means that the jitter is effectively zero compared to other sources of error, e.g. drift in the reference clock frequency.

Another advantage with the fractional divider system according to the present invention is that it is implemented with very low hardware complexity.

A further advantage in this connection is achieved if said fractional divider means comprises an accumulator means operable to keep track of the total timing error, and in that said fractional divider system also comprises a counting means operable to count the number of high speed clocks from the ideal timing reference to the first pulse of the low power reference clock, thereby measuring the timing error, which is used to adjust the value in said accumulator means such that the late start of the measurement is compensated for.

In this connection, a further advantage is achieved if said measured timing error is used by said accumulator means to adjust the preload value for said high speed clock divider means on leaving said low-power mode.

A further advantage in this connection if said fractional divider system also comprises a to said high speed crystal oscillator means connected wake-up timer means operable to bring said fractional divider system out of low-power mode, either due to the expiry of said wake-up timer means or due to an external signal requesting that said fractional divider system wakes up.

In this connection, a further advantage is achieved if said fractional divider system also comprises an to said wake-up timer means connected integer divider means operable to divide the reference clock with an integer division ratio of either M or M + 1.

A further advantage in this connection is achieved if said fractional divider system also comprises a to said integer divider means connected ratio selector means operable to keep the total timing error as small as possible while being positive.

In this connection, a further advantage is achieved if said current timing error value stored in said accumulator means is denoted k, the number of cycles of said high speed clock required for said value k is given as:

$$n_{HS} = kX \frac{T_{LP}}{P_{DIV} T_{HS}}$$

, wherein $T_{LP}$ is the time period for said low-power reference clock, and $T_{HS}$ is the time period for said high speed crystal oscillator means, with the values $T_{LP}$, $T_{HS}$ and $T_{LP}$ chosen such that the number of high speed clock cycles required is a convenient integer multiple of the value k.

A further advantage in this connection is achieved if said fractional divider system also comprises a first synchroniser means connected to said accumulator means, said high speed crystal oscillator means and said high speed clock divider means, wherein said first synchroniser means output said preload value to said high speed clock divider means.

In this connection, a further advantage is achieved if said fractional divider system also comprises a second synchroniser means connected to said integer divider means, said high speed crystal oscillator means and said high speed clock divider means, wherein the output from said second synchroniser means triggers said high speed clock divider means.

A further advantage in this connection is achieved if said fractional divider system also comprises an adding means connected to said accumulator means, a subtracting means connected to said accumulator means, and a multiplexer means connected to said adding means, said subtracting means and said ratio selector means, wherein the output from said multiplexer means is input to said accumulator means.

The above-mentioned problems are also solved with a method for reducing timing error at wakeup for low-power timer according to claim 11. The method comprises the steps:

- a fractional divider means produces an output signal with a frequency $F_C$ with the following relation to a reference clock frequency $F_{LP}$;

$$F_{LP} = \left( M + \frac{N}{P_{DIV}} \right) \times F_C$$

, wherein $P_{DIV}$ is the period of said fractional divider means, M is the integer part of the division ratio, and N is the magnitude of the fractional part of the division ratio;
- to sample said output signal;
- to sample a current state of the total timing error;
- to trigger, with said sampled output signal, a high speed clock divider means;
- to preload said high speed clock divider means with said sampled current state of the total timing error;

and
- to synchronise the first pulse of the output clock signal to the ideal clock timing to an accuracy within 1,5 periods of the high speed clock.

An advantage with the method for reducing timing error at wakeup for low-power timer according to the present invention is that the timing jitter due to the method can be reduced to 1,5 high speed clock cycles, i.e. a small fraction of a microsecond. This means that the jitter is effectively zero compared to other sources of error, e.g. drift in the reference clock frequency.

A further advantage in this connection is achieved if said method also comprises the steps:

- to count the number of high speed clocks from the ideal timing reference to the first pulse of the low-power reference clock; and
- to adjust the preload value such that the late start of the measurement is compensated for.

In this connection, a further advantage is achieved if said method also comprises the step:

- to exit said low-power mode, either due to the expiry of a wake-up time means, or due to an external signal requesting wake up.

A further advantage in this connection is achieved if said method also comprises the step:

- to divide the reference clock with an integer division ratio of either M or
  M + 1.

In this connection, a further advantage is achieved if said method also comprises the step:

- to select said integer division ratio in such a way to keep the total timing error as small as possible while being positive.

A further advantage in this connection is achieved if said current timing error is denoted k, the number of cycles of said high speed clock required for said value k is given as:

$$n_{HS} = kX \frac{T_{LP}}{P_{DIV} T_{HS}}$$

, wherein $T_{LP}$ is the time period of a low-power reference clock, and $T_{HS}$ is the time period for a high speed crystal oscillator means, with the values $T_{LP}$, $T_{HS}$ and $T_{LP}$ chosen such that the number of high speed clock cycles required is a convenient integer multiple of the value k.

The above-mentioned problems are also solved with at least one computer program product according to claim 17. The at least one computer program product is directly loadable into the internal memory of at least one digital computer, and comprises software code portions for performing the steps in claim 11, when said at least one product is/are run on said at least one computer.

An advantage with the at least one computer program product according to the present invention is that the timing error due to the product can be reduced to 1,5 high speed clock cycles, i.e. a small fraction of a microsecond. This means that the jitter is effectively zero compared to other sources of errors, e.g. drift in the reference clock frequency. The present invention will in the following by way of embodiments be described in more detail, in conjunction with the enclosed drawings, in which:

Brief description of the drawings.

  Figure 1 is a block diagram of a fractional divider means according to the prior art;

  Figure 2 discloses in the form of Table 1 the operation of the fractional divider means disclosed in figure 1;

  Figure 3 is a block diagram of a fractional divider system according to the present invention;

  Figure 4 is a more detailed block diagram of the fractional divider system disclosed in figure 3;

  Figure 5 is a flow chart of a method for reducing timing error at wakeup for low-power timer according to the present invention;

  Figure 6 is a more detailed flow chart of the method disclosed in figure 5; and

  Figure 7 show some examples of computer program products according to the present invention.

Detailed description of embodiments.

In figure 3 there is disclosed a block diagram of a fractional divider system 100 for low-power timer with reduced timing error at wakeup according to the present invention. The fractional divider system 100 comprises a fractional divider means 102 operable to produce an output signal B with a frequency $F_C$ with the following relation to a reference clock frequency $F_{LP}$:

$$F_{LP} = \left( M + \frac{N}{P_{DIV}} \right) \times F_C$$

, wherein $P_{DIV}$ is the period of said fractional divider means 102, M is the integer part of the division ratio, and N is the magnitude of the fractional part of the division ratio. The input signal to said fractional divider means 102 is denoted A. The fractional divider system 100 also comprises a to said fractional divider means 102 connected high speed crystal oscillator means 104 operable to start on wakeup from the low power mode. The fractional divider system 100 also comprises a high speed clock divider means 106 connected to said fractional divider means 102 and to said high speed crystal oscillator means 104. The high speed crystal oscillator means 104 is also operable to sample the output signal B and a current state of the total timing error from said fractional divider means 102. The sampled output signal B trigger said high speed clock divider means 106 and said sampled current state of the total timing error preloads said high speed clock divider means 106. The high speed clock divider means 106 is operable to synchronise the first pulse of the output clock signal C to the ideal clock timing to an accuracy within 1,5 periods of the high speed clock.

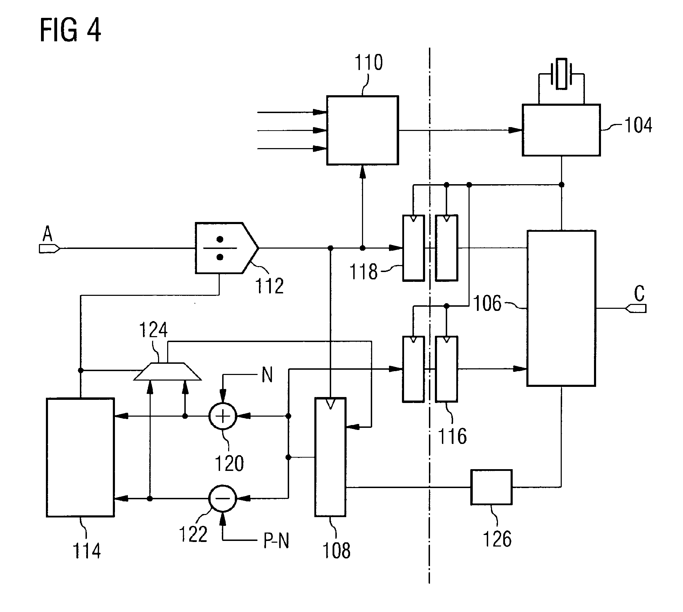

In figure 4 there is disclosed a more detailed block diagram of the fractional divider system 100 disclosed in figure 3. Some of the means/functional blocks in figure 4 corresponds to the same means/functional blocks in figures 1 and 3 and these have been allocated the same reference signs in figures 1,3 and 4 and will not be described again. The fractional divider system 100 disclosed in figure 4 also comprises a to said high speed crystal oscillator means 104 connected wake-up timer means 110 operable to bring said fractional divider system 100 out of the low-power mode. This is performed either due to the expiry of said wake-up timer means 110, or due to an external signal requesting that said fractional divider system 100 wakes up. The fractional divider system 100 also comprises a to said integer divider means 112 connected ratio selector means 114 operable to keep the total timing error as small as possible while being positive. The fractional divider system 100 also comprises a first synchroniser means 116 connected to said accumulator means 108, said high speed crystal oscillator means 104, and said high speed clock divider means 106. The first synchronizer means 116 outputs said preload value to said high speed clock divider means 106. The fractional divider system 100 also comprises a second synchroniser means 118 connected to said integer divider means 112, said high speed crystal oscillator means 104, and said high speed clock divider means 106. The output from said second synchroniser means 118 triggers said high speed clock divider means 106. The fractional divider system also comprises a counting means 126 connected to said high speed clock divider means 106, which counting means 126 is operable to count the number of high-speed clocks from the ideal timing reference to the first pulse of the low power reference clock, thereby measuring the timing error, which is used to adjust the value in said accumulator means 108 such that the late start of the measurement is compensated for. As is apparent from figure 4, said counting means 126 is also connected to said accumulator means 108.

According to another embodiment, the measured timing error is used by said accumulator means 108 to adjust the preload value for said high speed clock divider means 106 on leaving said low-power mode.

If said current timing error value stored in said accumulator means 108 is denoted k, the number of cycles of said high speed clock required for said value k is given as:

$$n_{HS} = kx \frac{T_{LP}}{P_{DIV} T_{HS}}$$

, wherein $T_{LP}$ is the time period for said low-power reference clock, and $T_{HS}$ is the time period for said high speed crystal oscillator means 104 with the values $T_{LP}$, $T_{HS}$ and $P_{DIV}$ chosen such that the number of high speed clock cycles required is a convenient integer multiple of the value k. Below will follow a description of the fractional divider system 100 according to the present invention with other words.

The invention is a modification to the fractional division circuit, where the high speed crystal oscillator that is activated upon the return from low-power mode is used to compensate for the timing error recorded in the accumulator. This means that the timing jitter due to the fractional divider can be reduced to 1.5 high-speed clock cycles, i.e. a small fraction of a microsecond. This means that the jitter is effectively zero compared to other sources of error (e.g. drift in the reference clock frequency).

The aim of the improved low-power timer circuit is to make use of the timing error that is stored in the fractional divider's accumulator, so that on exit from low-power mode (either due to reaching the programmed sleep duration or due to an external wake-up signal) the next pulse of the control clock is accurately aligned.

The improved low-power timer circuit is shown in figure 4. The structure of the fractional divider itself is essentially unchanged. However, instead of attempting to keep the error minimised symmetrically around zero, the ratio selector attempts to keep the error as small as possible while always being positive (i.e. the output clock always occurs slightly in advance of the ideal clock instant).

On wake-up from the low power mode, the high speed crystal oscillator is started. This is used to sample the output of the fractional divider and the current state of the accumulator, which are then passed to a high-speed clock divider which, in active mode, is responsible for maintaining the control clock. On leaving low power mode, the high-speed clock divider waits for a rising edge on the sampled low-power control clock. This is used to preload the high-speed divider with a value derived from the sampled timing error (accumulator of the fractional divider), such that the first pulse on the output clock is synchronised to the ideal clock timing to within 1.5 periods of the high-speed clock, which is negligible compared to other sources of timing error.

Denoting the current error value stored in the accumulator as k, the number of cycles of the high-speed clock required for a given accumulator value is given as:

$$n_{HS} = k \times \frac{T_{LP}}{P_{DIV} T_{HS}}$$

By selecting $P_{DIV} = T_{LP}/T_{HS}$, the right hand side of the equation becomes equal to one, i.e. no multiplication or division operation is needed to calculate the appropriate preload value. Alternatively, $P_{DIV}$ could be chosen such that the multiplication factor becomes a power of two (i.e. a simple shift operation), allowing more flexibility in how coarse a division ratio is implemented. It may also be desirable to subtract a constant offset from the preload value to compensate for the delay through the synchroniser and possible delays in other parts of the circuit.

The wake-up timer shown in the figure is responsible for bringing the system out of low-power mode, either due to expiry of the timer or due to an external signal requesting that the device wakes up. This is clocked by the low power reference clock, and counts the number of control clock pulses generated by the fractional divider. The generation of the enable signal to the crystal oscillator is timed such that the crystal oscillator has time to stabilise before the flank of the control clock that represents the programmed wake-up instant. In the event of an external wake-up signal, the number of elapsed control clocks may be read out by the system after receiving the trigger pulse to the high-speed clock divider.

The basic fractional divider circuit, and the improved circuit as described so far, has one remaining problem. It is desired to maintain a timing reference defined relative to the high-speed clock: however, the low power timing reference is derived from the 32kHz reference clock and this is asynchronous to the high-speed clock. Therefore, there is an unknown delay of up to an entire reference clock cycle before the first pulse into the low-power fractional divider, which if uncorrected would directly translate into jitter of the output clock.

This problem can easily remedied by counting the number of high-speed clocks from the ideal timing reference to the first pulse of the 32kHz clock, thereby measuring the timing error. This may then be used to adjust the value in the accumulator of the fractional divider such that the late start of the measurement is compensated for, or may be used to adjust the preload value for the high-speed clock divider on leaving low-power mode. In both cases, measures must be taken to ensure that the required preload value for the high speed divider is non-negative (i.e. the output pulse from the low power divider arrives too late). This can be done by adjusting the division ratio for the first control clock pulse, and, if the preload adjustment is used, setting the target range of the timing error such that the control clock pulses from the low power divider are always sufficiently in advance of the ideal timing.

This circuit, with very low hardware complexity, allows for a timing reference to be maintained during a low power state which is limited essentially only by the drift of the external low power reference, e.g. some 10s of parts per million for a typical 32kHz clock.

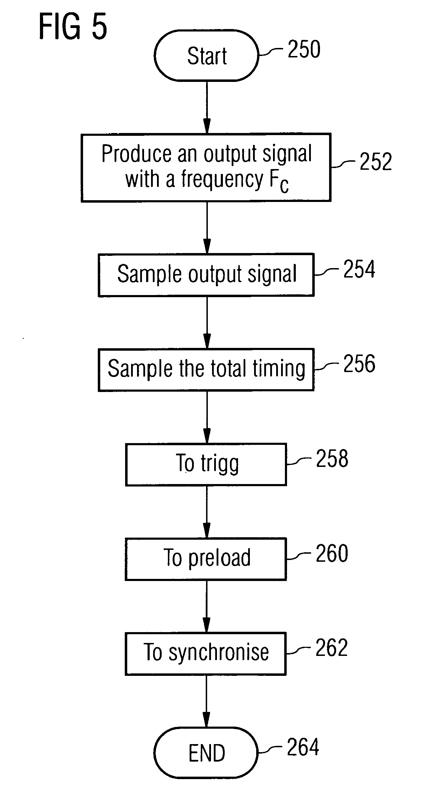

In figure 5 there is disclosed a flow chart of a method for reducing timing error at wakeup for low-power timer according to the present invention. The method begins at block 250. The method continues, at block 252, with the step: a fractional divider means produces an output signal with a frequency $F_C$ with the following relation to a reference clock frequency $F_{LP}$:

$$F_{LP} = \left( M + \frac{N}{P_{DIV}} \right) \times F_C$$

, wherein $P_{DIV}$ is the period of said fractional divider means, M is the integer part of the division ratio, and N is the magnitude if the fractional part of the division ratio. Thereafter, the method continues, at block 254, with the step: to sample said output signal. The method continues, at block 256, with the step: to sample a current state of the total timing error. Thereafter, the method continues, at block 258, with the step: to trigger, with said sampled output signal, a high speed clock divider means. The method continues, at block 260, with the step: to preload said high speed clock divider means with said sampled current state of the total timing error. Thereafter, the method continues, at block 262, with the step: to synchronise the first pulse of the output clock signal to the ideal clock timing to an accuracy within 1,5 periods of the high speed clock. The method is finished at block 264.

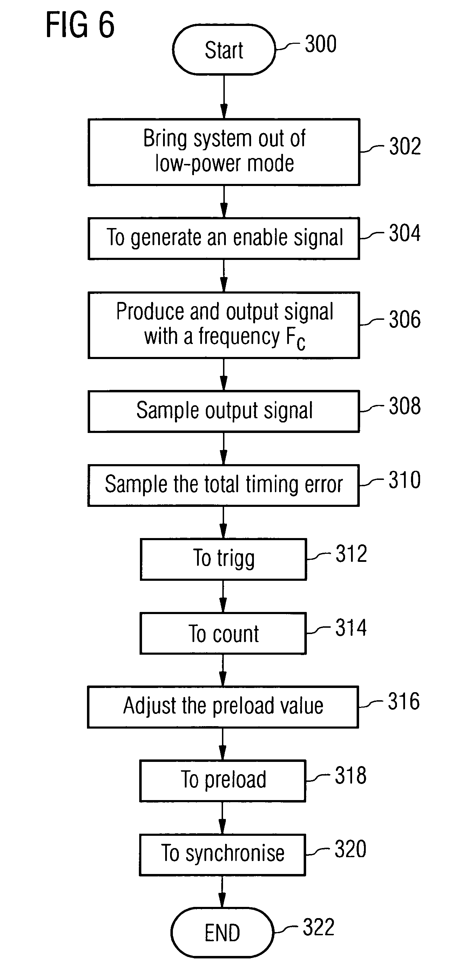

In figure 6 there is disclosed a more detailed flow chart of the method disclosed in figure 5. The method begins at block 300. The method continues, at block 302, with the step: to bring a fractional divider system out of low-power mode, either due to expiry of the timer or due to an external signal requesting that the system wakes up. Thereafter, the method continues, at block 304, with the step: to generate an enable signal to a high speed crystal oscillator means. The method continues, at block 306, with the step: a fractional divider means produces an output signal with a frequency $F_C$ with the following relation to a reference clock frequency $F_{LP}$:

$$F_{LP} = \left( M + \frac{N}{P_{DIV}} \right) \times F_C$$

, wherein $P_{DIV}$ is the period of said fractional divider means, M is the integer part of the division ratio, and N is the magnitude of the fractional part of the division ratio. Thereafter, at block 308, with the step: to sample said output signal. The method continues, at block 310, with the step: to sample a current state of the total timing error. Thereafter, the method continues, at block 312, with the step: to trigger, with said sampled output signal, a high speed clock divider means. The method continues, at block 314, with the step: to count the number of high-speed clocks from the ideal timing reference to the first pulse of the low-power reference clock. Thereafter, the method continues, at block 316, with the step: to adjust the preload value such that the late start of the measurement is compensated for. The method continues, at block 318, with the step: to preload said high speed clock divider means, with said adjusted preload value. Thereafter the method continues, at block 320, with the step: to synchronise the first pulse of the output clock signal to the ideal clock timing to an accuracy within 1,5 periods of the high speed clock. The method is finished at block 322.

According to a preferred embodiment of said method, it also comprises the step: to divide the reference clock with an integer division ratio of either M or M+1.

According to another preferred embodiment of said method, it also comprises the step: to select said integer division ratio in such a way to keep the total timing error as small as possible while being positive.

According to yet another preferred embodiment of said method, if said current timing error is denoted k, the number of cycles of said high speed clock required for said value k is given as:

$$n_{HS} = k \times \frac{T_{LP}}{P_{DIV} T_{HS}}$$

, wherein $T_{LP}$ is the time period of a low-power reference clock, and $T_{HS}$ is the time period for a high speed crystal oscillator means, with the values $T_{LP}$, $T_{HS}$ and $P_{DIV}$ chosen such that the number of high speed clock cycles required is a convenient integer multiple of the value k.

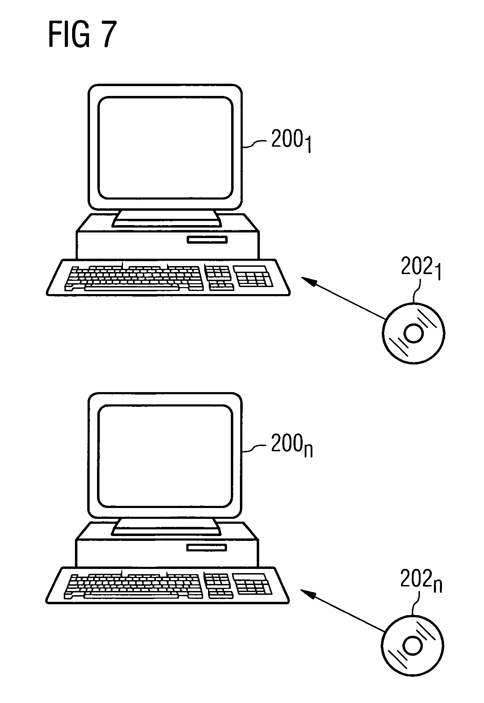

In figure 7 there is disclosed a schematic diagram of some computer program products according to the present invention. There is disclosed n different digital computers $200_1, ..., 200_n$, wherein n is an integer. There is also disclosed n different computer program products

$202_1$, ..., $202_n$, here showed in the form of compact discs. The different computer program products $202_1$, ..., $202_n$ are directly loadable into the internal memory of the n different digital computers $200_1$, ..., $200_n$. Each computer program product $202_1$, ..., $202_n$ comprises software code portions for performing some or all the steps of figure 5 when the product (s) $202_1$ ..., $202_n$ is/are run on said computer (s) $200_1$ ..., $200_n$. Said computer program products $202_1$, ..., $202_n$ can e. g. be in the form of floppy disks, RAM disks, magnetic tapes, opto magnetical disks or any other suitable products.

The invention is not limited to the embodiments described in the foregoing. It will be obvious that many different modifications are possible within the scope of the following claims.

**Claims**

1. A fractional divider system (100) for low-power timer with reduced timing error at wakeup, which fractional divider system (100) comprises a fractional divider means (102) operable to produce an output signal with a frequency $F_C$ with the following relation to a reference clock frequency $F_{LP}$:

$$F_{LP} = (M + \frac{N}{P_{DIV}})XF_c$$

,wherein $P_{DIV}$ is the period of said fractional divider means (102), M is the integer part of the division ratio, and N is the magnitude of the fractional part of the division ratio, **characterized in that** said fractional divider system (100) also comprises a to said fractional divider means (102) connected high speed crystal oscillator means (104) operable to start on wakeup from the low power mode, a to said fractional divider means (102) and to said high speed crystal oscillator means (104) connected high speed clock divider means (106), wherein said high speed crystal oscillator means (104) also is operable to sample the output signal and a current state of the total timing error from said fractional divider means (102), wherein said sampled output signal trigger said high speed clock divider means (106), and said sampled current state of the total timing error preloads said high speed clock divider means (106), which is operable to synchronize the first pulse of the output clock signal to the ideal clock timing to an accuracy within 1,5 periods of the high speed clock.

2. A fractional divider system (100) for low-power timer with reduced timing error at wakeup according to Claim 1, **characterized in that** said fractional divider means (102) comprises an accumulator means (108) operable to keep track of the total timing error, and **in that** said fractional divider system (100) also comprises a counting means (126) operable to count the number of high-speed clocks from the ideal timing reference to the first pulse of the low power reference clock, thereby measuring the timing error, which is used to adjust the value in said accumulator means (108) such that the late start of the measurement is compensated for.

3. A fractional divider system (100) for low-power timer with reduced timing error at wake-up according to Claim 2, **characterized in that** said measured timing error is used by said accumulator means (108) to adjust the preload value for said high speed clock divider means (106) on leaving said low-power mode.

4. A fractional divider system (100) for low-power timer with reduced timing error at wake-up according to any one of Claims 1 - 3, **characterized in that** said fractional divider system (100) also comprises a to said high speed crystal oscillator means (104) connected wake-up timer means (110) operable to bring said fractional divider system (100) out of low-power mode, either due to the expiry of said wake-up timer means (110) or due to an external signal requesting that said fractional divider system (100) wakes up.

5. A fractional divider system (100) for low-power timer with reduced timing error at wake-up according to Claim 4, **characterized in that** said fractional divider system (100) also comprises an to said wake-up timer means (110) connected integer divider means (112) operable to divide the reference clock with an integer division ratio of either M or M + 1.

6. A fractional divider system (100) for low-power timer with reduced timing error at wake-up according to Claim 5, **characterized in that** said fractional divider system (100) also comprises a to said integer divider means (112) connected ratio selector means (114) operable to keep the total timing error as small as possible while being positive.

7. A fractional divider means (100) for low-power timer with reduced timing error at wake-up according to any one of Claims 2 - 6, **characterized in that**, if said current timing error value stored in said accumulator means (108) is denoted k, the number of cycles of said high speed clock required for said value k is given as:

$$n_{HS} = kX \frac{T_{LP}}{P_{DIV} T_{HS}}$$

, wherein $T_{LP}$ is the time period for said low-power reference clock, and $T_{HS}$ is the time period for said high speed crystal oscillator means (104), with the values $T_{LP}$, $T_{HS}$ and $P_{DIV}$ chosen such that the number of high speed clock cycles required is a convenient integer multiple of the value k.

8. A fractional divider system (100) for low-power timer with reduced timing error at wake-up according to Claim 7, **characterized in that** said fractional divider system (100) also comprises a first synchroniser means (116) connected to said accumulator means (108), said high speed crystal oscillator means (104) and said high speed clock divider means (106), wherein said first synchroniser means (116) output said preload value to said high speed clock divider means (106).

9. A fractional divider system (100) for low-power timer with reduced timing error at wake-up according to Claim 8, **characterized in that** said fractional divider system (100) also comprises a second synchroniser means (118) connected to said integer divider means (112), said high speed crystal oscillator means (104) and said high speed clock divider means (106), wherein the output from said second synchroniser means (118) triggers said high speed clock divider means (106).

10. A fractional divider system (100) for low-power timer with reduced timing error at wake-up according to Claim 9, **characterized in that** said fractional divider system (100) also comprises an adding means (120) connected to said accumulator means (108), a subtracting means (122) connected to said accumulator means (108), and a multiplexer means (124) connected to said adding means (120), said subtracting means (122) and said ratio selector means (114), wherein the output from said multiplexer means (124) is input to said accumulator means (108).

11. A method for reducing timing error at wakeup for low-power timer, which method comprises the steps of:

   - a fractional divider means produces an output signal with a frequency $F_C$ with the following relation to a reference clock frequency $F_{LP}$;

$$F_{LP} = (M + \frac{N}{P_{DIV}}) X F_C$$

   , wherein $P_{DIV}$ is the period of said fractional divider means, M is the integer part of the division ratio, and N is the magnitude of the fractional part of the division ratio;
   - to sample said output signal;

   - to sample a current state of the total timing error;
   - to trigger, with said sampled output signal, a high speed clock divider means;
   - to preload said high speed clock divider means with said current state of the total timing error, and
   - to synchronise the first pulse of the output clock signal to the ideal clock timing to an accuracy within 1,5 periods of the high speed clock.

12. A method for reducing timing error at wakeup for low-power timer according to Claim 11, **characterized in that** said method also comprises the steps:

   - to count the number of high-speed clocks from the ideal timing reference to the first pulse of the low-power reference clock; and
   - to adjust the preload value such that the late start of the measurement is compensated for.

13. A method for reducing timing error at wakeup for low-power timer according to Claim 12, **characterized in that** said method also comprises the step:

   - to exit said low-power mode, either due to the expiry of a wake-up time means, or due to an external signal requesting wake up.

14. A method for reducing timing error at wakeup for low-power timer according to Claim 13, **characterized in that** said method also comprises the step:

   - to divide the reference clock with an integer division ratio of either M or M + 1.

15. A method for reducing timing error at wakeup for low-power for timer according to Claim 14, **characterized in that** said method also comprises the step:

   - to select said integer division ratio in such a way to keep the total timing error as small as possible while being positive.

16. A method for reducing timing error at wakeup for low-power timer according to any one of Claims 12 -15, **characterized in that**, if said current timing error is denoted k, the number of cycles of said high speed clock required for said value k is given as:

$$n_{HS} = k X \frac{T_{LP}}{P_{DIV} T_{HS}}$$

   , wherein $T_{LP}$ is the time period of a low-power reference clock, and $T_{HS}$ is the time period for a high speed crystal oscillator means, with the values $T_{LP}$,

$T_{HS}$ and $P_{DIV}$ chosen such that the number of high speed clock cycles required is a convenient integer multiple of the value k.

17. At least one computer program product ($202_1$, ..., $202_n$) directly loadable into the internal memory of at least one digital computer ($200_1$, ..., $200_n$), comprising software code portions for performing the steps of Claim 11 when said at least one product ($202_1$, ..., $202_n$) is/are run on said at least one computer ($200_1$, ..., $200_n$).

# FIG 1

# FIG 2

| Output cycle | Selection | Time of next output (reference clocks) | Ideal time of next output (reference clocks) | Error | New accumulator |
|---|---|---|---|---|---|
| 0 | M | M | M+0.1 | 0.1 | 1 |
| 1 | M | 2M | 2M+0.2 | 0.2 | 2 |
| 2 | M | 3M | 3M+0.3 | 0.3 | 3 |
| 3 | M | 4M | 4M+0.4 | 0.4 | 4 |
| 5 | M | 5M | 5M+0.5 | 0.5 | 5 |
| 6 | M | 6M+1 | 6M+0.6 | -0.4 | -4 |
| 7 | M | 7M+1 | 7M+0.7 | -0.3 | -3 |
| 8 | M | 8M+1 | 8M+0.8 | -0.2 | -2 |
| 9 | M | 9M+1 | 9M+0.9 | -0.1 | -1 |
| 10 | M | 10M+1 | 10M+1 | 0 | 0 |

# FIG 3

EP 1 612 942 A1

# FIG 4

FIG 5

Start — 250

Produce an output signal
with a frequency $F_c$ — 252

Sample output signal — 254

Sample the total timing — 256

To trigg — 258

To preload — 260

To synchronise — 262

END — 264

## FIG 6

```
                    ┌─────────────┐
                    │    Start    │──── 300
                    └─────────────┘
                           │
                           ▼
              ┌─────────────────────────┐
              │   Bring system out of   │──── 302
              │     low-power mode      │
              └─────────────────────────┘
                           │
                           ▼
              ┌─────────────────────────┐
              │ To generate an enable signal │──── 304
              └─────────────────────────┘
                           │
                           ▼
              ┌─────────────────────────┐
              │  Produce and output signal │──── 306
              │    with a frequency F_c  │
              └─────────────────────────┘
                           │
                           ▼
              ┌─────────────────────────┐
              │    Sample output signal  │──── 308
              └─────────────────────────┘
                           │
                           ▼
              ┌─────────────────────────┐
              │  Sample the total timing error │──── 310
              └─────────────────────────┘
                           │
                           ▼
                 ┌──────────────────┐
                 │     To trigg     │──── 312
                 └──────────────────┘
                           │
                           ▼
                 ┌──────────────────┐
                 │     To count     │──── 314
                 └──────────────────┘
                           │
                           ▼
              ┌─────────────────────────┐
              │   Adjust the preload value │──── 316
              └─────────────────────────┘
                           │
                           ▼
                 ┌──────────────────┐
                 │    To preload    │──── 318
                 └──────────────────┘
                           │
                           ▼
                 ┌──────────────────┐
                 │  To synchronise  │──── 320
                 └──────────────────┘
                           │
                           ▼
                    ┌─────────────┐
                    │     END     │──── 322
                    └─────────────┘
```

# FIG 7

$200_1$

$202_1$

$200_n$

$202_n$

European Patent
Office

**EUROPEAN SEARCH REPORT**

Application Number

EP 04 01 5423

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 6 725 067 B1 (MARX GERALD ET AL) 20 April 2004 (2004-04-20) * column 5, lines 14-29; figure 1 * * column 8, line 45 - column 9, line 11 * * column 12, lines 62-66 * ----- | 1-17 | H03K23/66 |
| A | US 2001/027096 A1 (LINDLAR HERIBERT) 4 October 2001 (2001-10-04) * paragraphs [0017], [0027], [0036] * ----- | 1,11 | |
| A | US 6 449 329 B1 (HALTER STEVEN J) 10 September 2002 (2002-09-10) * column 2, line 63 - column 4, line 55; figure 1 * ----- | 1-16 | |
| A | EP 0 954 105 A (SIEMENS AG) 3 November 1999 (1999-11-03) * paragraph [0038]; figure 7 * ----- | 1,11 | |
| A | US 6 504 498 B1 (O'BRIEN JEREMIAH CHRISTOPHER) 7 January 2003 (2003-01-07) * column 4, line 60 - column 5, line 60; figure 3 * * column 1, lines 28-49 * ----- | | **TECHNICAL FIELDS SEARCHED (Int.Cl.7)** H03K H03L |

The present search report has been drawn up for all claims

| Place of search | Date of completion of the search | Examiner |
|---|---|---|
| Munich | 27 October 2004 | Moll, P |

EPO FORM 1503 03.82 (P04C01)

## ANNEX TO THE EUROPEAN SEARCH REPORT
## ON EUROPEAN PATENT APPLICATION NO.

EP 04 01 5423

This annex lists the patent family members relating to the patent documents cited in the above-mentioned European search report.
The members are as contained in the European Patent Office EDP file on
The European Patent Office is in no way liable for these particulars which are merely given for the purpose of information.

27-10-2004

| Patent document cited in search report | | Publication date | Patent family member(s) | | Publication date |
|---|---|---|---|---|---|
| US 6725067 | B1 | 20-04-2004 | NONE | | |
| US 2001027096 | A1 | 04-10-2001 | DE | 10009683 A1 | 30-08-2001 |
| | | | EP | 1130791 A2 | 05-09-2001 |
| | | | JP | 2001274737 A | 05-10-2001 |
| US 6449329 | B1 | 10-09-2002 | AU | 9107901 A | 26-03-2002 |
| | | | CA | 2422328 A1 | 21-03-2002 |
| | | | CN | 1475046 T | 11-02-2004 |
| | | | EP | 1317798 A1 | 11-06-2003 |
| | | | JP | 2004509499 T | 25-03-2004 |
| | | | WO | 0223725 A1 | 21-03-2002 |
| EP 0954105 | A | 03-11-1999 | EP | 0954105 A1 | 03-11-1999 |
| US 6504498 | B1 | 07-01-2003 | AU | 1493801 A | 30-04-2001 |
| | | | AU | 1962501 A | 30-04-2001 |
| | | | AU | 2112501 A | 10-05-2001 |
| | | | AU | 7724500 A | 30-04-2001 |
| | | | AU | 7724800 A | 30-04-2001 |
| | | | AU | 7834700 A | 30-04-2001 |
| | | | WO | 0124357 A1 | 05-04-2001 |
| | | | WO | 0124415 A1 | 05-04-2001 |
| | | | WO | 0124420 A1 | 05-04-2001 |
| | | | WO | 0126260 A1 | 12-04-2001 |
| | | | WO | 0124537 A2 | 05-04-2001 |
| | | | WO | 0124376 A1 | 05-04-2001 |

EPO FORM P0459

For more details about this annex : see Official Journal of the European Patent Office, No. 12/82